(19) Europäisches Patentamt / European Patent Office / Office européen des brevets

(11) **EP 4 390 431 A1**

(12) **EUROPEAN PATENT APPLICATION**

(43) Date of publication:
**26.06.2024 Bulletin 2024/26**

(21) Application number: **22214558.3**

(22) Date of filing: **19.12.2022**

(51) International Patent Classification (IPC):
**G01R 33/387** (2006.01)   **G01R 33/565** (2006.01)
**G01R 33/44** (2006.01)   *G01R 33/3815* (2006.01)
**G01R 33/56** (2006.01)

(52) Cooperative Patent Classification (CPC):
**G01R 33/387; G01R 33/445; G01R 33/56563;**
G01R 33/3815; G01R 33/5608

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Koninklijke Philips N.V.
5656 AG Eindhoven (NL)**

(72) Inventors:
• **FORTHMANN, Peter
  Eindhoven (NL)**
• **LEUSSLER, Christoph Günther
  Eindhoven (NL)**

(74) Representative: **Philips Intellectual Property &
Standards
High Tech Campus 52
5656 AG Eindhoven (NL)**

(54) **METHOD AND SYSTEM FOR MAGNETIC RESONANCE IMAGING PROCESSING**

(57)  According to the invention a method of processing an acquired magnetic resonance image is provided, with the following steps:

S 1) providing a first magnetic resonance image which has been acquired with a magnetic resonance imaging device (1) at a first main magnetic field with a first magnetic flux density at shimming conditions for shimming a second main magnetic field to uniformity, wherein the second main magnetic field has a second magnetic flux density which is different from the first magnetic flux density,

S2) providing a second magnetic resonance image which has been acquired with the magnetic resonance imaging device (1) at the second main magnetic field at shimming conditions for shimming the second main magnetic field to uniformity,

S3) providing a first operator,

S4) providing a second operator,

S5) retrieving a magnetic resonance image which would be expected instead of the first magnetic resonance image if the first magnetic resonance image had been acquired with the magnetic resonance imaging device (1) at the first main magnetic field at shimming conditions for shimming the first main magnetic field to uniformity by applying the second operator onto the first magnetic resonance image and applying the first operator onto the magnetic resonance image which has been received by applying the second operator onto the first magnetic resonance image.

Fig. 1

**Description**

FIELD OF THE INVENTION

The invention relates to the field of magnetic resonance imaging. More particularly, the present invention relates to the field of processing a magnetic resonance image acquired with a magnetic resonance imaging device.

BACKGROUND OF THE INVENTION

High-temperature superconductors enable magnets to be ramped very quickly, which in turn enables magnetic resonance imaging devices to be constructed employing a switchable magnetic flux density of the main magnetic field. This allows intra-examination magnetic flux density switching of the main magnetic field to a further magnetic flux density of a further main magnetic field of the magnetic resonance imaging device. For example, imaging is carried out at a main magnetic field of 1.5 T. Subsequent switching of the high-temperature superconductor would cause a change in magnetic flux density to a further main magnetic field of 0.6 T and enable acquisition of further magnetic resonance images at this lower magnetic flux density. However, the shimming is still set so that the main magnetic field at, for example, 1.5 T is homogeneous. The further main magnetic field shows inhomogeneities due to the change in magnetic flux density, because the shimming was not performed for the further magnetic flux density different from the first magnetic flux density.

Shimming in general is the process that provides the maximum possible homogenization of the main magnetic field. A distinction is made between active and passive shimming. Passive shimming is carried out by placing and positioning ferromagnetic materials on the inside of the magnet forming the main magnetic field and serves to minimize the inhomogeneities caused by the design of the magnetic resonance imaging device. Active shimming can be carried out using shim coils provided for this purpose. Active shimming homogenizes the inhomogeneities in the main magnetic field caused by the patient load.

The inhomogeneities caused by the change in the magnetic flux density of the main magnetic field cause image artifacts in the magnetic resonance imaging device that cannot be sufficiently reduced by active shimming.

The article 'Feasibility study of novel rapid ramp-down procedure in MgB2 MRI magnet using persistent current switch with high off-resistivity' by Kodama et. al. in Superconductor Science and Technology, 34 (2021) 074003 (13pp); describes dry magnets with high-temperature superconductors and MgB2, which are provided with a novel fast shutdown method that can replace controlled shutdown in emergencies. For this purpose, it is provided to establish a power supply by means of a persistent current switch, which is switched off when heated and the power supply is interrupted by means of a breaker. The energy stored in the solenoid is consumed at an external resistor.

Accurate homogenization of the main magnetic field is critical in magnetic resonance imaging to reduce inhomogeneity artifacts in the magnetic resonance image. However, with existing rampable magnetic resonance imaging scanners and the ability to change the main magnetic field, homogenization of the main magnetic field by shimming is not sufficient.

SUMMARY OF THE INVENTION

It is an objective of the invention to provide a time and memory efficient method for reducing the effects of magnetic field inhomogeneities in magnetic resonance images.

According to the invention, this object is addressed by the subject matter of the independent claims. Preferred embodiments of the invention are described in the dependent claims.

Therefore, according to the invention, a method of processing an acquired magnetic resonance image is provided, the method comprising the following steps: providing a first magnetic resonance image which has been acquired with a magnetic resonance imaging device at a first main magnetic field with a first magnetic flux density at shimming conditions for shimming a second main magnetic field to uniformity, wherein the second main magnetic field has a second magnetic flux density which is different from the first magnetic flux density, providing a second magnetic resonance image which has been acquired with the magnetic resonance imaging device at the second main magnetic field at shimming conditions for shimming the second main magnetic field to uniformity, providing a first operator for transforming a magnetic resonance image which has been acquired with the magnetic resonance imaging device at the first main magnetic field at shimming conditions for shimming the first main magnetic field to uniformity into a magnetic resonance image which would be expected at the second magnetic field at shimming conditions for shimming the second main magnetic field to uniformity, providing a second operator for transforming a magnetic resonance image which has been acquired with the magnetic resonance imaging device at the first main magnetic field at shimming conditions for shimming the second main magnetic field to uniformity into a magnetic resonance image which would be expected at the first magnetic field at shimming conditions for shimming the first main magnetic field to uniformity, retrieving a magnetic resonance image which would be expected instead of the first magnetic resonance image if the first magnetic resonance image had been acquired with the magnetic resonance imaging device at the first main magnetic field at shimming conditions for shimming the first main magnetic field to uniformity by applying the second operator onto the first magnetic resonance image and applying the first operator onto the magnetic resonance image which has been received by applying the second operator onto the first magnetic resonance image.

An operator is generally a mapping or function that acts on elements of a space to produce elements of another space. The term can be used as a synonym for functions or for the application of a machine learning algorithm to the elements of a space. The actual elements in this space are the first magnetic resonance image and the second magnetic resonance image with the respective first and second operator.

The term "shimming a main magnetic field to uniformity" means that such a shimming is applied with which image distortions due to field inhomogeneities are reduced. However, while such shimming may help to greatly reduce field inhomogeneities, such shimming will never be able to achieve a completely uniform main magnetic field.

Further, it will not be possible to generate operators which work perfectly, i.e. which are able to exactly calculate the expected image from a given image. If this would be the case, the second operator alone would be sufficient to reconstruct a correctly shimmed image from a badly shimmed image, i.e. an image which has been acquired at shimming conditions for another main magnetic field with higher or lower magnetic flux density. Therefore, according to the invention, the second operator is used together with the first operator, the first magnetic resonance image and the second magnetic resonance image in order to reconstruct the magnetic resonance image which would have been expected instead of the first magnetic resonance image if the first magnetic resonance image had been acquired with the magnetic resonance imaging device at the first main magnetic field at correct shimming conditions for shimming the first main magnetic field to uniformity.

This allows a time efficient and resource saving approach to unlock the full functionality of a magnetic resonance imaging device comprising a switchable magnetic flux density. The transformation of the first magnetic resonance image with the two operators provides a time efficient method to examine a patient intra examination with the magnetic resonance imaging device being switchable into two different modes, two magnetic flux densities, without the need to adjust the passive or active shimming between the two magnetic flux densities. In particular, passive shimming, which involves changing the main magnetic field by introducing ferromagnetic materials, is a resource-intensive shimming method to achieve the homogenization of the magnetic field. The use of operators for the transformation of the magnetic resonance images enables new magnetic resonance imaging possibilities, for example the reduction of susceptibility artifacts or the like by magnetic resonance image acquisition at different magnetic flux densities. Furthermore, by forming the operators, a computationally and memory efficient approach is chosen in particular. Once the operators have been constructed, the training data for the magnetic resonance imaging device where the first magnetic resonance image and the second magnetic resonance image originate from are no longer required, thus achieving a synergistic effect with the first and the second operator, since the first operator does not necessarily have to be generated locally at the magnetic resonance imaging device in question.

According to the invention, various algorithms may be used for the last step in which the operators are applied. However, according to a preferred embodiment of the invention, the method for performing the last step comprises a trained machine learning algorithm representing the action of the first operator and the second operator which, upon input of the first magnetic resonance image and the second magnetic resonance image, generates the magnetic resonance image that would be expected instead of the first magnetic resonance image if the first magnetic resonance image had been acquired with the magnetic resonance imaging device at the first main magnetic field at shimming conditions for shimming the first main magnetic field to uniformity.

This means in particular that the intermediate result may not necessarily be available to a user of the system when the first operator is applied, but remains internal to the trained machine learning algorithm and only the final result is accessible. Thus, these operators can be execution steps in the trained machine learning algorithm that cannot be accessed. For example, in a trained artificial neural network, these operators may be the activation functions in the nodes of the respective levels of this trained artificial neural network.

In principle, it is possible for the training data set to include various data. According to a preferred embodiment of the invention, however, the method further comprises the training data set for developing the first operator in the trained machine learning algorithm including the magnetic resonance images acquired with the first main magnetic field at shimming conditions for shimming the first main magnetic field to uniformity, and the magnetic resonance images acquired at the second main magnetic field at shimming conditions for the second main magnetic field to uniformity.

Magnetic resonance images acquired with the first main magnetic field at shimming conditions for shimming the first main magnetic field to uniformity and the magnetic resonance images acquired at the second main magnetic field at shimming conditions for the second main magnetic field to uniformity are thereby fed in pairs building the training data set to the machine learning algorithm. For this purpose, in situ and in vivo magnetic resonance images of humanoid subjects, animal subjects or special magnetic resonance imaging phantoms intended as substitute for in vivo magnetic resonance imaging can be acquired at the different magnetic flux densities. The training data set can include the respective magnitude images as well as the phase images.

In general, it is possible to generate the training data set for the first operator in various ways. According to a preferred embodiment of the invention, however, the method further comprises that the training dataset for developing the first operator in the trained machine learning algorithm is generated with a generative adversarial network formed from two artificial neural networks.

The magnetic resonance images acquired with the first main magnetic field at shimming conditions for shimming the first main magnetic field to uniformity and the magnetic resonance images acquired at the second main magnetic field at shimming conditions for the second main magnetic field to uniformity can be generated by employing the generative adversarial network formed from two artificial neural networks to generate the training data for the first operator without the need for additional in vivo or in situ acquisition of magnetic resonance images.

According to a preferred embodiment of the invention the method further comprises that the training dataset for developing the first operator in the trained machine learning algorithm is generated with electromagnetic simulations.

With these electromagnetic simulations, for example, Maxwell's equations for a given problem can be solved in a simulation environment to derive the first operator accordingly.

It is possible to generate the training data set for the second operator in various ways. According to a preferred embodiment of the invention, however, the method further comprises that the training data set for developing the second operator in the trained machine learning algorithm includes the magnetic resonance images of a magnetic resonance imaging phantom acquired with the first main magnetic field at shimming conditions for shimming the second main magnetic field to uniformity, and the magnetic resonance images of the magnetic resonance imaging phantom acquired at the second main magnetic field at shimming conditions for the second main magnetic field to uniformity.

Thus, the training data set contains the differences between the first magnetic resonance image and the second magnetic resonance image and by this a direct measure for the magnetic field inhomogeneities generated by the change of the magnetic flux density. The machine learning algorithm can be trained to compensate for these inhomogeneities using the second operator. This effect is magnetic resonance imaging device-specific from the magnetic resonance imaging device where the first magnetic resonance image and the second magnetic resonance image originate from.

Preferably, the trained machine learning algorithm for the second operator is a trained artificial neural network.

In principle, different methods may be provided to approximate the magnetic resonance image that would be expected instead of the first magnetic resonance image if the first magnetic resonance image had been acquired with the magnetic resonance imaging device at the first main magnetic field under shimming conditions for shimming the first main magnetic field for uniformity. According to a preferred embodiment of the invention, however, the method further comprises that in the last step the magnetic resonance image which would be expected instead of the first magnetic resonance image if the first magnetic resonance image had been acquired with the magnetic resonance imaging device at the first main magnetic field at shimming conditions for shimming the first main magnetic field to uniformity is retrieved by minimizing a loss function which uses the first magnetic resonance image and the second magnetic resonance image and the first operator and the second operator.

With the minimization of the loss function, the first magnetic resonance image converges to the magnetic resonance image which would be expected instead of the first magnetic resonance image if the first magnetic resonance image had been acquired with the magnetic resonance imaging device at the first main magnetic field at shimming conditions for shimming the first main magnetic field to uniformity. This is a process that can never be perfect, and therefore regularly proceeds in an iterative asymptotic approximation. Therefore, it can be provided that this loss function stops the calculation of the magnetic resonance image that would be expected instead of the first magnetic resonance image if the first magnetic resonance image had been acquired with the magnetic resonance imaging device at the first main magnetic field at shimming conditions for shimming the first main magnetic field to uniformity, when reaching a certain iteration threshold which can be defined by a user. Similarly, it is possible that the minimization of the loss function yields local minima instead of global minima. Basically, however, the artifacts in the magnetic resonance image that would have to be expected are reduced compared to the first magnetic resonance image.

It is possible to employ different implementations of minimizing a loss function. According to a preferred embodiment of the invention, however, the method further comprises that for the loss function LF the following formula applies:

$$LF = Operator1(Operator2(Image1)) - Image2,$$

with Operator 1 being the first operator, Operator 2 being the second operator, Image 1 being the first image and Image 2 being the second image.

This loss function iteratively minimizes the distance between the second magnetic resonance image and the first magnetic resonance image on which the first operator and the second operator were applied. In this minimization of the loss function, the first operator and the second operator are entered as initial values, which can be changed during the iterative minimization using the loss function.

In general, it is possible for different magnetic resonance imaging devices to be used to acquire the magnetic resonance images for the first operator. According to a preferred embodiment of the invention, however, the method further comprises that the first operator has been obtained by including the magnetic resonance image properties of magnetic resonance images acquired at the first main magnetic field at shimming conditions for shimming the first main magnetic field to uniformity and of magnetic resonance images acquired at the second main magnetic field at shimming conditions for shimming the second main magnetic field to uniformity, wherein the magnetic resonance images acquired at the first main magnetic field and the second main magnetic field, respectively, have not been acquired with the magnetic resonance imaging device where the first magnetic resonance image and the second magnetic resonance image originate from.

Thus, the first operator is independent of the magnetic resonance imaging device where the first magnetic resonance image and the second magnetic resonance image originate from and it is not necessary to determine the operator for each specific magnetic resonance imaging device. That is, this first operator needs to be determined only once.

According to a preferred embodiment of the invention the method further comprises that the second operator is obtained by acquiring magnetic resonance images from the magnetic resonance imaging phantom simulating a patient load at the first main magnetic field and at the second main magnetic field, and the difference between the acquired magnetic resonance images of the magnetic resonance imaging phantom at the first main magnetic field and the second main magnetic field includes the effect of the inhomogeneities of the first main magnetic field with the first magnetic flux density at shimming conditions for shimming the second main magnetic field to uniformity.

Further, according to the invention, a computer program for magnetic resonance imaging modification is provided, comprising instructions which, when the program is executed by a computer, cause the computer to perform a method as described above.

The invention further provides a system of a magnetic resonance imaging device and a computing unit, the magnetic resonance imaging device with a switch with which the main magnetic field is switchable, with a first main magnetic field comprising a first magnetic flux density with shimming conditions for shimming a second main magnetic field to uniformity, with the second main magnetic field comprising a second magnetic flux density with shimming conditions for shimming the second main magnetic field to uniformity, wherein the second magnetic flux density is different from the first magnetic flux density, wherein the computing unit is adapted to execute the method as described above.

By allowing the magnetic flux density to change to a lower or higher flux density, artifacts in magnetic resonance images that depend on the magnetic flux density can be compensated.

In principle, different superconducting magnets can be employed. According to a preferred embodiment of the invention, however, a superconducting magnet is provided for generating the first main magnetic field and the second main magnetic field, and the superconducting magnet is a dry magnet.

Preferably, the superconducting magnet used to generate the first main magnetic field and the second main magnetic field is a high-temperature superconductor.

High-temperature superconductors allow the superconducting magnet to switch rapidly between the first magnetic flux density and the second magnetic flux density.

Even more preferably, the superconducting magnet used to generate the first main magnetic field and the second main magnetic field is a magnesium diboride magnet.

BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:

Fig. 1 schematically depicts a scheme of a method according to a preferred embodiment of the invention; and

Fig. 2 schematically depicts a system of a magnetic resonance imaging device and a computing unit according to a preferred embodiment of the invention.

DETAILED DESCRIPTION OF EMBODIMENTS

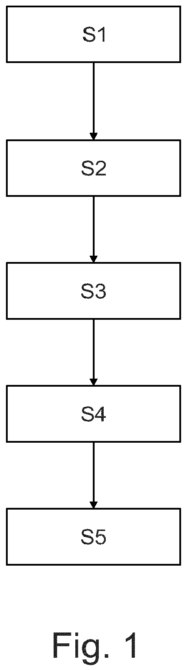

Fig. 1 schematically depicts a scheme of a method according to a preferred embodiment of the invention. This method comprises steps S1 to S5.

S 1: First, a first magnetic resonance image which has been acquired with a magnetic resonance imaging device 1 at a first main magnetic field with a first magnetic flux density at shimming conditions for shimming a second main magnetic field to uniformity is provided, wherein the second main magnetic field has a second magnetic flux density which is different from the first magnetic flux density,

S2: Second, a second magnetic resonance image which has been acquired with the magnetic resonance imaging device 1 at the second main magnetic field at shimming conditions for shimming the second main magnetic field to uniformity is provided,

S3: Third, a first operator for transforming a magnetic resonance image which has been acquired with the magnetic resonance imaging device 1 at the first main magnetic field at shimming conditions for shimming the first main magnetic field to uniformity into a magnetic resonance image which would be expected at the second magnetic field at shimming conditions for shimming the second main magnetic field to uniformity is provided,

S4: Fourth, a second operator for transforming a magnetic resonance image which has been acquired with the magnetic resonance imaging device 1 at the first main magnetic field at shimming conditions for shimming the second main magnetic field to uniformity into a magnetic resonance image which would be expected at the first magnetic field at shimming conditions for shimming the first main magnetic field to uniformity is provided,

S5: Fifth, a magnetic resonance image which would be expected instead of the first magnetic resonance image if the first magnetic resonance image had been acquired with the magnetic resonance imaging device 1 at the first main magnetic field at shimming conditions for shimming the first main magnetic field to uniformity is retrieved by applying the second operator onto the first magnetic resonance image and applying the first operator onto the magnetic resonance image which has been received by applying the second operator onto the first magnetic resonance image.

The first operator is generated by a trained machine learning algorithm that has been trained with magnetic resonance images acquired with the first main magnetic field at shimming conditions for shimming the first main magnetic field to uniformity, and the magnetic resonance images acquired at the second main magnetic field at shimming conditions for the second main magnetic field to uniformity. These images have not been acquired with the magnetic resonance imaging device 1 where the first magnetic resonance image and the second magnetic resonance image originate from. This first operator is only deduced once and is valid for the combination of the first magnetic flux density and the second magnetic flux density for the given set of scan parameters for which they have been determined. In case the scan parameters would change, e.g. if repetition time (TR) or echo time (TE) would change and, therefore, a different image contrast would be achieved, a new determination would be necessary.

The second operator is also generated by a trained machine learning algorithm that has been trained with a training data including the magnetic resonance images of a magnetic resonance imaging phantom 5 for simulating a patient load acquired with the first main magnetic field at shimming conditions for shimming the second main magnetic field to uniformity, and the magnetic resonance images of the magnetic resonance imaging phantom 5 acquired at the second main magnetic field at shimming conditions for the second main magnetic field to uniformity at the respective set of given scan parameters.

The first and the second operator are then implemented into a loss function in order to retrieve the magnetic resonance image which would be expected instead of the first magnetic resonance image if the first magnetic resonance image had been acquired with the magnetic resonance imaging device 1 at the first main magnetic field at shimming conditions for shimming the first main magnetic field to uniformity by minimizing this loss function which, uses the first magnetic resonance image and the second magnetic resonance image and the first operator and the second operator.

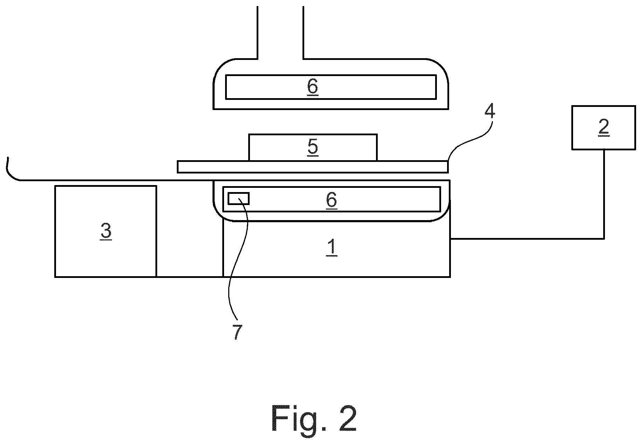

Fig. 2 schematically depicts a system of the magnetic resonance imaging device 1 and a computing unit 2 according to a preferred embodiment of the invention. The main magnetic field in the bore of the magnetic resonance imaging device 1 is generated by a superconducting magnet 6, which is a high temperature superconductor. The magnetic flux density of the main magnetic field generated by the superconducting magnet 6 is switchable by a switch 7 between the first main magnetic field with the first magnetic flux density at shimming conditions for shimming the second main magnetic field to uniformity and the second main magnetic field at shimming conditions for shimming the second main magnetic field to uniformity having the second magnetic flux density different from the first magnetic flux density.

The magnetic resonance imaging phantom 5 is arranged on a treatment couch 4 of a patient positioning system 3. The switch 7 is connected to the computing unit 2 and can be controlled by it. Further, the computing unit 2 is adapted to perform the method of steps S1-S5 and thus obtain the magnetic resonance image which would be expected instead of the first magnetic resonance image if the first magnetic resonance image had been acquired with the magnetic resonance imaging device at the first main magnetic field at shimming conditions for shimming the first main magnetic field to uniformity by applying the second operator onto the first magnetic resonance image and applying the first operator onto the magnetic resonance image which has been received by applying the second operator onto the first magnetic resonance image, then calculates the magnetic resonance image according to the first operator onto the first magnetic resonance image and the second operator onto the second magnetic resonance image.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

REFERENCE SYMBOL LIST

1.    Magnetic resonance imaging device
2.    Computing unit
3     Patient positioning system
4.    Treatment couch
5.    Magnetic resonance imaging phantom
6.    Superconducting magnet
7.    Switch

**Claims**

1.    Method of processing an acquired magnetic resonance image, the method comprising the following steps:

S1) providing a first magnetic resonance image which has been acquired with a magnetic resonance imaging device (1) at a first main magnetic field with a first magnetic flux density at shimming conditions for shimming a second main magnetic field to uniformity, wherein the second main magnetic field has a second magnetic flux density which is different from the first magnetic flux density,
S2) providing a second magnetic resonance image which has been acquired with the magnetic resonance imaging device (1) at the second main magnetic field at shimming conditions for shimming the second main magnetic field to uniformity,
S3) providing a first operator for transforming a magnetic resonance image which has been acquired with the magnetic resonance imaging device (1) at the first main magnetic field at shimming conditions for shimming the first main magnetic field to uniformity into a magnetic resonance image which would be expected at the second magnetic field at shimming conditions for shimming the second main magnetic field to uniformity,
S4) providing a second operator for transforming a magnetic resonance image which has been acquired with the magnetic resonance imaging device (1) at the first main magnetic field at shimming conditions for shimming the second main magnetic field to uniformity into a magnetic resonance image which would be expected at the first magnetic field at shimming conditions for shimming the first main magnetic field to uniformity,
S5) retrieving a magnetic resonance image which would be expected instead of the first magnetic resonance image if the first magnetic resonance image had been acquired with the magnetic resonance imaging device (1) at the first main magnetic field at shimming conditions for shimming the first main magnetic field to uniformity by applying the second operator onto the first magnetic resonance image and applying the first operator onto the magnetic resonance image which has been received by applying the second operator onto the first magnetic resonance image.

2.    Method according to claim 1, wherein for performing the step S5, a trained machine learning algorithm representing the action of the first operator and the second operator is provided which, upon input of the first magnetic resonance image and the second magnetic resonance image, generates the magnetic resonance image that would be expected instead of the first magnetic resonance image if the first magnetic resonance image had been acquired with the magnetic resonance imaging device (1) at the first main magnetic field at shimming conditions for shimming the first main magnetic field to uniformity.

3.    Method according to claim 2, wherein the training data set for developing the first operator in the trained machine learning algorithm includes the magnetic resonance images acquired with the first main magnetic field at shimming conditions for shimming the first main magnetic field to uniformity, and the magnetic resonance images acquired at the second main magnetic field at shimming conditions for the second main magnetic field to uniformity.

4.    Method according to claim 3, wherein the training dataset for developing the first operator in the trained machine learning algorithm is generated with a generative adversarial network formed from two artificial neural networks.

5.    Method according to any of claims 2 to 4, wherein the training dataset for developing the first operator in the trained machine learning algorithm is generated with electromagnetic simulations.

6.    Method according to any of claims 2 to 5, wherein the training data set for developing the second operator in the trained machine learning algorithm includes the magnetic resonance images of a magnetic resonance imaging phantom (5) for simulating a patient load acquired with the first main magnetic field at shimming conditions for shimming the second main magnetic field to uniformity, and the magnetic resonance images of the magnetic resonance imaging phantom (5) acquired at the second main magnetic field at shimming conditions for the second main magnetic field to uniformity.

7. Method according to any of the previous claims, wherein in step S5 the magnetic resonance image which would be expected instead of the first magnetic resonance image if the first magnetic resonance image had been acquired with the magnetic resonance imaging device (1) at the first main magnetic field at shimming conditions for shimming the first main magnetic field to uniformity is retrieved by minimizing a loss function which uses the first magnetic resonance image and the second magnetic resonance image and the first operator and the second operator.

8. Method according to claim 7, wherein for the loss function LF the following formula applies:

$$LF = Operator1(Operator2(Image1)) - Image2,$$

with Operator 1 being the first operator, Operator 2 being the second operator, Image 1 being the first image and Image 2 being the second image.

9. Method according to any of the previous claims, wherein the first operator has been obtained by including the magnetic resonance image properties of magnetic resonance images acquired at the first main magnetic field at shimming conditions for shimming the first main magnetic field to uniformity and of magnetic resonance images acquired at the second main magnetic field at shimming conditions for shimming the second main magnetic field to uniformity, wherein the magnetic resonance images acquired at the first main magnetic field and the second main magnetic field, respectively, have not been acquired with the magnetic resonance imaging device (1) where the first magnetic resonance image and the second magnetic resonance image originate from.

10. Method according to any of the previous claims, wherein the second operator is obtained by acquiring magnetic resonance images from the magnetic resonance imaging phantom (5) simulating a patient load at the first main magnetic field and at the second main magnetic field, and the difference between the acquired magnetic resonance images of the magnetic resonance imaging phantom (5) at the first main magnetic field and the second main magnetic field includes the effect of the inhomogeneities of the first main magnetic field with the first magnetic flux density at shimming conditions for shimming the second main magnetic field to uniformity.

11. Computer program for magnetic resonance imaging modification, comprising instructions which, when the program is executed by a computer, cause the computer to perform a method according to any one of claims 1 to 10.

12. System of a magnetic resonance imaging device (1) and a computing unit (2), the magnetic resonance imaging device (1) with a switch (7) with which the main magnetic field is switchable, with a first main magnetic field comprising a first magnetic flux density with shimming conditions for shimming a second main magnetic field to uniformity, with the second main magnetic field comprising a second magnetic flux density with shimming conditions for shimming the second main magnetic field to uniformity, wherein

the second magnetic flux density is different from the first magnetic flux density, wherein the computing unit (2) is adapted to execute the method to any of claims 1 to 11.

13. System according to claim 12, wherein a superconducting magnet (6) is provided for generating the first main magnetic field and the second main magnetic field, and the superconducting magnet is a dry magnet.

Fig. 1

Fig. 2

Europäisches
Patentamt

European
Patent Office

Office européen
des brevets

# EUROPEAN SEARCH REPORT

Application Number

EP 22 21 4558

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2020/400764 A1 (STAINSBY JEFF ALAN [CA] ET AL) 24 December 2020 (2020-12-24) * paragraph [0002] - paragraph [0007] * * paragraph [0023] * * paragraph [0037] - paragraph [0038] * * paragraph [0044] * | 1-13 | INV. G01R33/387 G01R33/565 G01R33/44 ADD. G01R33/3815 |
| A | RIGLA JUAN P ET AL: "Low-Field Rampable Magnet for a High-Resolution MRI System", IEEE TRANSACTIONS ON MAGNETICS, IEEE, USA, vol. 56, no. 2, 11 January 2020 (2020-01-11), pages 1-7, XP011766695, ISSN: 0018-9464, DOI: 10.1109/TMAG.2019.2950891 [retrieved on 2020-01-16] * abstract, last paragraph of section I, sections II.A and II.D * | 1-13 | G01R33/56 |
| A | LIAO PU ET AL: "Referenceless distortion correction of gradient-echo echo-planar imaging under inhomogeneous magnetic fields based on a deep convolutional neural network", COMPUTERS IN BIOLOGY AND MEDICINE, NEW YORK, NY, US, vol. 100, 18 July 2018 (2018-07-18), pages 230-238, XP085439097, ISSN: 0010-4825, DOI: 10.1016/J.COMPBIOMED.2018.07.010 * abstract, sections 1, 2.2, 2.3, 3, first paragraph of section 4 * | 1-13 | |

**TECHNICAL FIELDS SEARCHED (IPC)**

G01R

The present search report has been drawn up for all claims

| Place of search | Date of completion of the search | Examiner |
|---|---|---|
| Munich | 7 May 2023 | Lebar, Andrija |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 22 21 4558**

**07-05-2023**

| Patent document cited in search report | | Publication date | Patent family member(s) | | Publication date |
|---|---|---|---|---|---|
| US 2020400764 | A1 | 24-12-2020 | CA 3084781 | A1 | 24-12-2020 |
| | | | GB 2587866 | A | 14-04-2021 |
| | | | US 2020400764 | A1 | 24-12-2020 |
| | | | US 2021116524 | A1 | 22-04-2021 |

# EP 4 390 431 A1

**Non-patent literature cited in the description**

- **KODAMA.** Feasibility study of novel rapid ramp-down procedure in MgB2 MRI magnet using persistent current switch with high off-resistivity. *Superconductor Science and Technology,* 2021, vol. 34, 13